# EUROPÄISCHE PATENTSCHRIFT

(11) **EP 3 311 179 B1**
(45) Veröffentlichungstag und Bekanntmachung des Hinweises auf die Patenterteilung: **26.07.2023**
(21) Anmeldenummer: 16723770.0
(22) Anmeldetag: 20.05.2016
(51) Int. Cl.: G01R 31/62, G01R 31/72

(54) **PRÜFVORRICHTUNG UND VERFAHREN ZUM BETREIBEN EINER PRÜFVORRICHTUNG**
TEST DEVICE AND METHOD FOR OPERATING A TEST DEVICE
DISPOSITIF DE TEST ET PROCÉDÉ PERMETTANT DE FAIRE FONCTIONNER UN TEL DISPOSITIF

(30) Priorität: 17.06.2015 AT 505032015
(43) Veröffentlichungstag der Anmeldung: 25.04.2018
(73) Patentinhaber: Omicron electronics GmbH, 6833 Klaus (AT)
(72) Erfinder: KAUFMANN, Reinhard, 6721 Thüringerberg (AT); FLAX, Dirk, 6850 Dornbirn (AT)
(74) Vertreter: Banzer, Hans-Jörg
(86) Internationale Anmeldenummer: PCT/EP2016/061401
(87) Internationale Veröffentlichungsnummer: WO 2016/202523

(56) Entgegenhaltungen:
- US-A- 5 172 067
- Anonymous: "B-R040TD-EN-200 RMO40TD Brochure 1 On-Load Tap Changer Analysis", , 24. Januar 2013 (2013-01-24), XP055295605, Gefunden im Internet: URL:http://testnordic.com/media/743/rmo40t d.pdf [gefunden am 2016-08-16]
- BRASCA C ET AL: "An Active Ripple Filtering Technique for Improving Common-Mode Inductor Performance", IEEE POWER ELECTRONICS LETTERS, IEEE SERVICE CENTER, NEW YORK, NY, US, vol. 2, no. 2, 1 June 2004 (2004-06-01), pages 45-50, XP011117208, ISSN: 1540-7985, DOI: 10.1109/LPEL.2004.831155

## Beschreibung

### GEBIET DER ERFINDUNG

Ausführungsbeispiele der Erfindung betreffen eine Prüfvorrichtung zum Prüfen energietechnischer Einrichtungen, beispielsweise eines Transformators, und Verfahren zum Betreiben derartiger Prüfvorrichtungen. Ausführungsbeispiele der Erfindung betreffen insbesondere derartige Vorrichtungen und Verfahren, mit denen wenigstens eine Kenngröße eines Transformators ermittelt werden kann.

### HINTERGRUND

Transformatoren werden als Bestandteile von Energieversorgungsnetzen verwendet. Transformatoren können zur Spannungswandlung von einem ersten Wert an einer Oberspannungsseite zu einem zweiten Wert, der kleiner als der erste Wert ist, an einer Unterspannungsseite eingesetzt werden.

Die Bestimmung von Eigenschaften Transformators durch eine Prüfung, bei der eine oder mehrere charakteristische Kenngrößen des Transformators durch Messung ermittelt werden, ist beispielsweise zur Gewährleistung der Betriebssicherheit, zur Ansteuerung oder aus weiteren Gründen erforderlich. Beispiele für derartige Messungen beinhalten die Bestimmung eines statischen Widerstands, eines Übersetzungsverhältnisses, einer Streuinduktivität oder Streureaktanz. Prüfvorrichtungen für Einrichtungen der Energietechnik können nicht nur für Transformatoren, sondern auch zur Prüfung anderer Einheiten wie Schutzschalter oder Schutzrelais ausgelegt sein.

Prüfvorrichtungen können zum Prüfen energietechnischer Einrichtungen wie Transformatoren oder Wandlern eingerichtet sein, die eine Induktivität aufweisen. Beispielsweise können derartige Prüfvorrichtungen zur Prüfung eines Transformators eingerichtet sein, der eine Induktivität umfasst, in der vorübergehend Energie gespeichert wird.

In verschiedenen Betriebssituationen während einer Prüfung eines Prüflings kann es wünschenswert sein, die in der Induktivität gespeicherte Energie wieder abzubauen, beispielsweise zu dissipieren. Beispiele für derartige Betriebssituationen beinhalten das Ende einer Prüfung eines Prüflings oder das Ende eines Prüfungsschritts einer mehrere Schritte umfassenden Prüfungsprozedur. Weitere Beispiele beinhalten Notabschaltungen der Prüfvorrichtung im Fehlerfall.

Zum Reduzieren der in der Induktivität des Prüflings gespeicherten Energie können beispielsweise ein oder mehrere Widerstände verwendet werden. Derartige Techniken weisen jedoch den Nachteil auf, dass der Abbau der in der Spule gespeicherten Energie immer noch verhältnismäßig lang sein kann. Dies kann aus unterschiedlichen Gründen unerwünscht sein. Beispielsweise kann es aus Sicherheitsgründen wünschenswert sein, die in der Induktivität gespeicherte Energie relativ rasch abzubauen. Ein Verfahren zum Abbau der Energie in einer Induktivität finden sich in dem Dokument US5172067.

### ZUSAMMENFASSUNG DER ERFINDUNG

Es besteht ein Bedarf an Vorrichtungen und Verfahren, mit denen eine Stromstärke eines in einer Induktivität eines Prüflings fließenden Stroms verringert werden kann. Es besteht insbesondere ein Bedarf an derartigen Vorrichtungen und Verfahren, mit denen die Stromstärke des Stroms in der Induktivität des Prüflings rasch verringert werden kann und die in einfacher und kompakter Weise realisiert werden können.

Die Erfindung wird in den unabhängigen Ansprüchen 1,10 und 11 definiert. Bevorzugte Ausgestaltungen finden sich in den abhängigen Ansprüchen.

Nach Ausführungsbeispielen ist vorgesehen, eine Stromstärke eines in einer Induktivität fließenden Stroms nicht mit rein passiven Elementen zu reduzieren, sondern durch eine steuerbare Einrichtung aktiv zu reduzieren. Die steuerbare Einrichtung kann so steuerbar sein, dass elektrische Energie nicht nur vom Prüfgerät zum Prüfling, sondern auch von der Induktivität des Prüflings zurück in das Prüfgerät fließen kann, um eine Stromstärke eines Stroms in der Induktivität zu reduzieren. Die steuerbare Einrichtung kann so steuerbar sein, dass Stromfluss und Spannung in der steuerbaren Einrichtung in entgegengesetzte Richtungen zeigen, so dass die steuerbare Einrichtung Energie dissipiert, wenn sie derart angesteuert wird, dass Stromfluss und Spannung in der steuerbaren Einrichtung in entgegengesetzte Richtungen zeigen.

Die steuerbare Einrichtung kann ein Vier-Quadranten-Verstärker sein oder einen solchen Verstärker umfassen. Der Vier-Quadranten-Verstärker kann derart steuerbar sein, dass Stromfluss und Spannung in der steuerbaren Einrichtung in dieselbe Richtung zeigen, um dadurch Energie in der Induktivität zu speichern, und kann darüber hinaus derart steuerbar sein, dass Stromfluss und Spannung in der steuerbaren Einrichtung in entgegengesetzte Richtungen zeigen, so dass zur Reduktion des in der Induktivität fließenden Stroms Energie dissipiert wird.

Die steuerbare Einrichtung kann alternativ oder zusätzlich einen bi-direktionalen DC/DC-Wandler umfassen, um Energie, die von der Induktivität des Prüflings in das Prüfgerät zurückfließt, in ein Netz zurückzuspeisen.

Die Induktivität kann eine Spule oder eine andere Induktivität eines Transformators oder Wandlers sein, mit dem das Prüfgerät für eine Prüfung verbindbar ist.

Durch die Verwendung einer derartigen steuerbaren Einrichtung kann die Zeit, die zum Verringern der Stromstärke benötigt wird, verringert werden. Der für eine Prüfung des Prüflings benötigte Zeitaufwand kann verringert werden und/oder eine raschere Abschaltung im Fehlerfall wird ermöglicht.

Die steuerbare Einrichtung kann eingerichtet sein, um die von der Induktivität in das Prüfgerät zurückfließende Energie im Prüfgerät zu dissipieren, beispielsweise durch Umwandlung in Wärme. Dazu kann die steuerbare Einrichtung einen 4-Quadranten-Verstärker umfassen.

Die steuerbare Einrichtung kann eingerichtet sein, um die von der Induktivität in das Prüfgerät zurückfließende Energie über das Prüfgerät in ein Netz zurückspeisen. Dazu kann die steuerbare Einrichtung einen bi-direktionalen Wandler umfassen, um die von dem Prüfling in das Prüfgerät zurückfließende Leistung über das Prüfgerät in das Netz zurückzuspeisen.

Die Ansteuerung der steuerbaren Einrichtung zur Reduzierung der Stromstärke des in der Induktivität fließenden Stroms kann als Sicherheitsfunktion ausgeführt werden, beispielsweise als Reaktion auf eine Betätigung eines Not-Aus-Schalters. Die Ansteuerung der steuerbaren Einrichtung zur Reduzierung der Stromstärke des in der Induktivität fließenden Stroms kann zwischen unterschiedlichen Prüfschritten einer Prüfungsprozedur ausgeführt werden, um die für die Prüfung insgesamt benötigte Zeit zu verringern. Die Ansteuerung der steuerbaren Einrichtung zur Reduzierung der Stromstärke des in der Induktivität fließenden Stroms kann alternativ oder zusätzlich in einem Fehlerfall erfolgen, in dem die in der Induktivität des Prüflings gespeicherte Energie rasch abgebaut werden soll.

Die Prüfvorrichtung umfasst eine steuerbare Einrichtung zum Reduzieren einer Stromstärke eines in der Induktivität des Prüflings fließenden Stroms.

Die steuerbare Einrichtung kann eingerichtet sein, um zum Reduzieren der Stromstärke eine zeitabhängig veränderliche Gegenspannung zu erzeugen. Auf diese Weise kann die Stromstärke effizient verringert werden. Die Gegenspannung kann gemäß einer vordefinierten Steuer- oder Regelfunktion zeitabhängig angepasst werden.

Die Prüfvorrichtung kann eine Steuereinrichtung zum Steuern der steuerbaren Einrichtung in Abhängigkeit von einer erfassten Spannung und/oder einem erfassten Strom umfassen.

Die Steuereinrichtung kann eingerichtet sein, um die von der steuerbaren Einrichtung erzeugte Gegenspannung in einer Regelschleife einzustellen.

Die Steuereinrichtung kann für eine Leistungsregelung eingerichtet sein, bei der die in der steuerbaren Einrichtung dissipierte Leistung auf einen Leistungssollwert geregelt wird. In einer Betriebsphase, in der die Stromstärke der Induktivität des Prüflings nicht aktiv reduziert werden soll, kann die steuerbare Einrichtung so angesteuert werden, dass die Stromstärke geregelt wird.

Die Steuereinrichtung kann eingerichtet sein, um von einer weiteren Regelschleife zu der Regelschleife umzuschalten, wenn die Stromstärke in der Induktivität reduziert werden soll. Die weitere Regelschleife, die in einer Betriebsphase, in der die Stromstärke nicht reduziert werden soll, ausgeführt wird, kann eine Stromstärkeregelung des in der Induktivität fließenden Stroms umfassen.

Die steuerbare Einrichtung kann eingerichtet sein, um die Gegenspannung derart zu erzeugen, dass ein Betrag der Gegenspannung während eines Zeitintervalls monoton zunimmt.

Die Prüfvorrichtung kann eingerichtet sein, um zum Erzeugen eines in der Induktivität fließenden Stroms über die steuerbare Einrichtung der Induktivität Energie zuzuführen und um zum Reduzieren der Stromstärke in der Induktivität gespeicherte Energie über die steuerbare Einrichtung zu dissipieren. Auf diese Weise kann die Anzahl der benötigten Komponenten verringert werden, da dieselbe Einrichtung sowohl zum Speichern von Energie als auch zum Entladen der Induktivität verwendet werden kann. Energie kann in der Induktivität beispielsweise dann gespeichert werden, wenn ein Prüfsignal an den Prüfling angelegt wird.

Die steuerbare Einrichtung umfasst einen Verstärker. Der Verstärker kann ein Leistungsverstärker sein. Der Verstärker kann ein Halbleiterverstärker sein.

Der Verstärker kann ein 4-Quadranten-Verstärker sein. Der 4-Quadranten-Verstärker ist derart steuerbar, dass Stromstärke und Spannung auch entgegensetzt gerichtet sein können.

Die Prüfvorrichtung kann als Transformatorprüfgerät oder als Wandlerprüfgerät ausgestaltet sein. Das Transformatorprüfgerät oder als Wandlerprüfgerät kann mobil, beispielsweise portabel sein.

Ein System nach einem Ausführungsbeispiel umfasst einen Prüfling, der eine Induktivität aufweist, und eine Prüfvorrichtung nach einem Ausführungsbeispiel, die mit dem Prüfling verbunden ist. Der Prüfling kann ein Transformator oder ein Wandler sein.

Der Transformator kann ein Zweiwicklungstransformator oder ein Dreiwicklungstransformator sein.

Der Transformator oder Wandler kann in einem Kraftwerk, einem Umspannwerk oder einer anderen Anlage zur Energieerzeugung und/oder Energieübertragung installiert sein. Der Transformator kann ein Transformator für ein Hoch- oder Mittelspannungsnetz sein.

Bei einem Verfahren nach einem Ausführungsbeispiel wird eine Prüfvorrichtung zum Prüfen eines Prüflings, der eine Induktivität umfasst, gesteuert. Das Verfahren umfasst ein Ansteuern einer steuerbaren Einrichtung der Prüfvorrichtung zum Reduzieren einer Stromstärke eines in der Induktivität fließenden Stroms.

Bei dem Verfahren kann die steuerbare Einrichtung so angesteuert werden, dass sie zum Reduzieren der Stromstärke eine zeitabhängig veränderliche Gegenspannung erzeugt. Auf diese Weise kann die Stromstärke effizient verringert werden. Die Gegenspannung kann gemäß einer vordefinierten Steuer- oder Regelfunktion zeitabhängig angepasst werden.

Die steuerbare Einrichtung kann bei dem Verfahren die von der Induktivität in das Prüfgerät zurückfließende Energie im Prüfgerät dissipieren, beispielsweise durch Umwandlung in Wärme.

Die steuerbare Einrichtung kann bei dem Verfahren die von der Induktivität in das Prüfgerät zurückfließende Energie über das Prüfgerät in ein Netz zurückspeisen.

Bei dem Verfahren kann die steuerbare Einrichtung in Abhängigkeit von einer erfassten Spannung und/oder einem erfassten Strom angesteuert werden, beispielsweise in Abhängigkeit von einem Ausgangsstrom des Prüfgeräts, e in Abhängigkeit von einer Ausgangsspannung des Prüfgeräts und/oder in Abhängigkeit von einer Zwischenkreisspannung des Prüfgeräts.

Bei dem Verfahren kann die von der steuerbaren Einrichtung erzeugte Gegenspannung in einer Regelschleife eingestellt werden. Alternativ oder zusätzlich kann die steuerbare Einrichtung so gesteuert werden, dass die von der steuerbaren Einrichtung im Prüfgerät dissipierte Leistung und/oder die von dem Prüfgerät in ein Netz zurück gespeiste Leistung auf einen Sollwert geregelt wird.

Bei dem Verfahren kann die steuerbare Einrichtung in einer ersten Weise angesteuert werden, um ein Prüfsignal an den Prüfling anzulegen oder einzuprägen. Die steuerbare Einrichtung kann in einer zweiten Weise angesteuert werden, wenn Energie, die in der Induktivität des Prüflings gespeichert ist, in dem Prüfgerät selbst oder durch Rückspeisung in ein Netz über das Prüfgerät dissipiert werden soll. Die Ansteuerung der steuerbaren Einrichtung zur Verringerung des in der Induktivität des Prüflings fließenden Stroms kann in einer Regelschleife erfolgen, bei der beispielsweise die von der steuerbaren Einrichtung dissipierte Leistung auf einen Leistungssollwert geregelt wird. Die Ansteuerung der steuerbaren Einrichtung zum Anlegen oder Einprägen eines Prüfsignals kann so erfolgen, dass beispielsweise der Ausgangsstrom oder eine Amplitude des Ausgangsstroms des Prüfgeräts auf einen Stromsollwert geregelt wird.

Bei dem Verfahren kann die Gegenspannung derart erzeugt werden, dass ein Betrag der Gegenspannung während eines Zeitintervalls monoton zunimmt.

Bei dem Verfahren kann die steuerbare Einrichtung, beispielsweise ein 4-Quadranten-Verstärker, so angesteuert werden, dass eine von der steuerbaren Einrichtung im Prüfgerät dissipierte Leistung auf einen Sollwert geregelt wird, während die Stromstärke des in der Induktivität fließenden Stroms abgebaut wird. Eine ausreichende Wärmeabfuhr von dem 4-Quadranten-Verstärker kann auf diese Weise gewährleistet werden.

Bei dem Verfahren kann die Gegenspannung derart erzeugt werden, dass der Betrag der Gegenspannung zunimmt, so lange eine Zwischenkreisspannung der Prüfvorrichtung konstant ist. Auf diese Weise kann die steuerbare Einrichtung insbesondere zur Reduzierung der Stromstärke in der Induktivität eines Wandlers der Prüfvorrichtung eingesetzt werden.

Bei dem Verfahren kann zum Einprägen eines Prüfsignals in den Prüfling, das zu einem Stromfluss in der Induktivität führt, über die steuerbare Einrichtung Energie zugeführt werden, und zum Reduzieren der Stromstärke kann in der Induktivität gespeicherte Energie über die steuerbare Einrichtung dissipiert werden. Auf diese Weise kann die Anzahl der benötigten Komponenten verringert werden, da dieselbe Einrichtung sowohl zum Speichern von Energie als auch zum Entladen der Induktivität verwendet werden kann.

Die steuerbare Einrichtung umfasst einen Verstärker. Der Verstärker kann ein Leistungsverstärker sein. Der Verstärker kann ein Halbleiterverstärker sein.

Der Verstärker kann ein 4-Quadranten-Verstärker sein. Der 4-Quadranten-Verstärker ist derart steuerbar, dass Stromstärke und Spannung auch entgegensetzt gerichtet sein können.

Die Prüfvorrichtung, die mit dem Verfahren gesteuert wird, kann als Transformatorprüfgerät oder Wandlerprüfgerät ausgestaltet sein. Das Transformatorprüfgerät oder Wandlerprüfgerät kann mobil, beispielsweise portabel sein.

Bei dem Verfahren kann die Prüfvorrichtung mit einem Transformator oder einem Wandler verbunden sein.

Der Transformator kann ein Zweiwicklungstransformator oder ein Dreiwicklungstransformator sein.

Der Transformator oder Wandler kann in einem Kraftwerk, einem Umspannwerk oder einer anderen Anlage zur Energieerzeugung und/oder Energieübertragung installiert sein. Der Transformator kann ein Transformator für ein Hoch- oder Mittelspannungsnetz sein.

Vorrichtungen, Verfahren und Systeme nach Ausführungsbeispielen erlauben eine effiziente Reduzierung der in einer Spule oder anderen Induktivität gespeicherten Energie, beispielsweise in einem Not-Aus-Fall. Alternativ oder zusätzlich kann über die steuerbare Einrichtung auch die in der Induktivität gespeicherte Energie verringert werden, wenn beispielsweise ein Prüfungsschritt einer Prüfungsprozedur abgeschlossen ist.

### KURZE BESCHREIBUNG DER FIGUREN

Die Erfindung wird nachfolgend unter Bezugnahme auf die Zeichnungen anhand bevorzugter Ausführungsformen näher erläutert. In den Zeichnungen bezeichnen identische Bezugszeichen identische Elemente.
Figur 1 zeigt eine Prüfvorrichtung nach einem Ausführungsbeispiel.
Figur 2 zeigt eine Prüfvorrichtung nach einem Ausführungsbeispiel.
Figur 3 ist ein Schaubild zur Erläuterung der Funktionsweise der Prüfvorrichtung nach einem Ausführungsbeispiel.
Figur 4 ist ein Schaubild zur Erläuterung der Funktionsweise der Prüfvorrichtung nach einem Ausführungsbeispiel.
Figur 5 ist ein Schaubild zur Erläuterung der Funktionsweise der Prüfvorrichtung nach einem Ausführungsbeispiel.
Figur 6 zeigt eine Prüfvorrichtung nach einem Ausführungsbeispiel.
Figur 7 ist ein Blockdiagramm einer Steuereinrichtung einer Prüfvorrichtung nach einem Ausführungsbeispiel.
Figur 8 ist ein Flussdiagramm eines Verfahrens nach einem Ausführungsbeispiel.
Figur 9 zeigt ein System mit einer Transformatorprüfvorrichtung nach einem Ausführungsbeispiel.

### DETAILLIERTE BESCHREIBUNG VON AUSFÜHRUNGSBEISPIELEN

Nachfolgend wird die vorliegende Erfindung anhand bevorzugter Ausführungsformen unter Bezugnahme auf die Zeichnungen näher erläutert. In den Figuren bezeichnen gleiche Bezugszeichen gleiche oder ähnliche Elemente. Die Figuren sind schematische Darstellungen verschiedener Ausführungsformen der Erfindung. In den Figuren dargestellte Elemente sind nicht notwendigerweise maßstabsgetreu dargestellt. Vielmehr sind die verschiedenen in den Figuren dargestellten Elemente derart wiedergegeben, dass ihre Funktion und ihr Zweck dem Fachmann verständlich werden.

In den Figuren dargestellte Verbindungen und Kopplungen zwischen funktionellen Einheiten und Elementen können auch als indirekte Verbindung oder Kopplung implementiert werden. Eine Verbindung oder Kopplung kann drahtgebunden oder drahtlos implementiert sein.

Nachfolgend werden Prüfvorrichtungen und Verfahren zum Prüfen eines Prüflings detailliert beschrieben. Der Prüfling kann ein Transformator oder Wandler für Hoch- oder Mittelspannungsnetze sein. Der Prüfling kann ein in einem Kraftwerk oder Umspannwerk installierter Transformator sein. Die Prüfvorrichtungen kann ein mobiles Gerät sein oder kann aus mehreren mobilen Geräten aufgebaut sein, um die Durchführung der Messungen an dem installierten Transformator zu erlauben. Der Prüfling weist eine Induktivität auf, die eine Spule oder eine Stromschiene sein kann.

Die Prüfvorrichtung weist eine steuerbare Einrichtung auf, die angesteuert wird, um in der Induktivität des Prüflings gespeicherte Energie abzubauen. Die steuerbare Einrichtung kann ein 4-Quadranten-Verstärker sein. Zum Abbauen von in der Induktivität gespeicherten Energie kann die steuerbare Einrichtung so angesteuert werden, dass Strom und Spannung in der steuerbaren Einrichtung entgegengesetzt gerichtet sind, so dass Energie in die Prüfvorrichtung zurückfließt und in der steuerbaren Einrichtung dissipiert wird. In diesem Betriebszustand wird die steuerbare Einrichtung im II. oder IV. Quadranten des U-I-Diagramms betrieben. Alternativ oder zusätzlich zu einer Dissipation, bei der die zurückfließende Energie im Prüfgerät in Wärme umgesetzt wird, kann wenigstens ein Teil der zurückfließenden Energie vom Prüfgerät in das Netz zurückgespeist werden.

Die Induktivität kann eine Spule eines Prüflings, insbesondere eine Spule eines Transformators einer energietechnischen Anlage sein.

Eine Verringerung der Stromstärke eines in der Induktivität fließenden Stroms kann beispielsweise erfolgen, wenn ein Not-Aus-Schalter der Prüfvorrichtung betätigt wird. Die steuerbare Einrichtung, z.B. der 4-Quadranten-Verstärker, kann dann so angesteuert werden, dass sie eine zeitabhängig veränderliche Gegenspannung zu einer über der Induktivität abfallenden Spannung erzeugt, um die Stromstärke zu verringern.

Die Prüfvorrichtungen und Verfahren können eingerichtet sein, um unterschiedliche Kenngrößen des Transformators oder eines anderen Prüflings automatisch zu bestimmen. Beispielsweise können ein oder mehrere Übersetzungsverhältnisse des Transformators automatisch bestimmt werden, ohne hierfür eine Umverdrahtung vornehmen zu müssen. Es können auch andere Kenngrößen wie statische oder dynamische Widerstände oder eine Streureaktanz und/oder eine Streuinduktivität des Transformators ermittelt werden. Dazu kann von der Prüfvorrichtung eine Prüfantwort ausgewertet werden, die als Reaktion auf ein Prüfsignal erfasst wird. Das Prüfsignal kann von der steuerbaren Einrichtung des Prüfgeräts erzeugt und an den Prüfling ausgegeben werden. Die Verringerung der Stromstärke des in der Induktivität fließenden Stroms kann unter Kontrolle einer Steuereinrichtung der Prüfvorrichtung erfolgen, beispielsweise wenn ein Not-Aus-Schalter betätigt wurde.

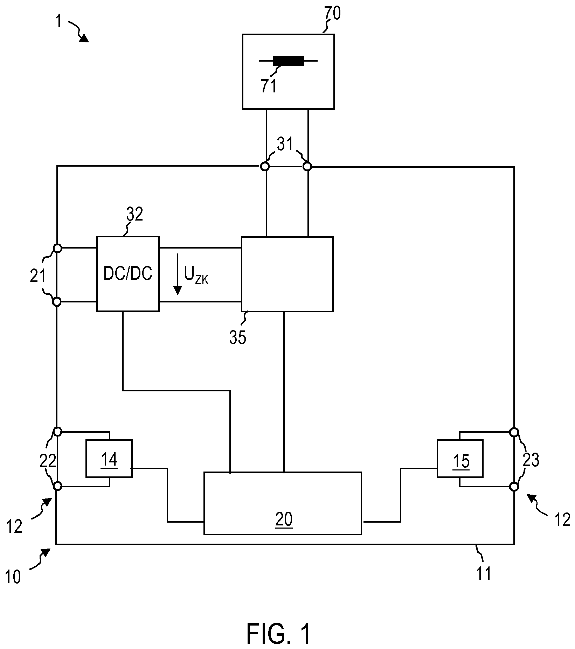

Figur 1 zeigt ein System 1, das eine Prüfvorrichtung 10 zum Ermitteln einer Kenngröße eines Prüflings nach einem Ausführungsbeispiel umfasst. Ein Ausgang 31 der Prüfvorrichtung 31 ist mit einem Prüfling 70 leitend verbunden. Die Prüfvorrichtung 10 kann zerstörungsfrei lösbar mit dem Prüfling 70 verbindbar sein, um ein Prüfsignal an den Prüfling 70 anzulegen oder in ihn einzuspeisen und um eine Prüfantwort des Prüflings 70 zu erfassen. Der Prüfling 70 kann ein Transformator sein. Der Prüfling 70 umfasst wenigstens eine Induktivität 71, die als Spule, Wicklung oder Stromschiene ausgebildet sein kann.

Die Prüfvorrichtung 10 kann als ein einziges Gerät mit einem Gehäuse 11 ausgebildet sein, wie in Figur 1 dargestellt ist. Die Prüfvorrichtung 10 kann aus einer Anordnung von mehreren Geräten oder Einrichtungen bestehen. Die mehreren Geräte oder Einrichtungen können in diesem Fall von einer zentralen Steuerung gesteuert werden. Die Prüfvorrichtung 10 kann ein Transformatorprüfgerät sein. Das Transformatorprüfgerät 10 kann als mobiles Gerät und insbesondere als ein portables Gerät ausgebildet sein.

Die Prüfvorrichtung 10 umfasst eine Mehrzahl von Anschlüssen 12 zur Verbindung mit dem Prüfling, einen Wandler 32 und eine Steuereinrichtung 20. Die Prüfvorrichtung 10 ist eingerichtet, um ein Prüfsignal für den Prüfling zu erzeugen und um eine Prüfantwort des Prüflings auszuwerten. Eine oder mehrere Messeinrichtungen 14, 15 zum Erfassen der Prüfantwort des Prüflings können in die Prüfvorrichtung 10 integriert sein. Ein oder mehrere steuerbare Schaltmittel können in die Prüfvorrichtung 10 integriert sein, beispielsweise um selektiv eine Primärseite oder eine Sekundärseite des Prüflings während der Prüfung kurzzuschließen. Die wenigstens eine Messeinrichtung 14, 15 und eine Steuereinrichtung 20 können in einem Gehäuse 11 des Transformatorprüfgeräts verbaut sein.

Der Wandler 32 kann eingerichtet sein, um eine Zwischenkreisspannung zu erzeugen. Ein derartiger Gleichstrom-Zwischenkreis ermöglicht die Erzeugung von Blindleistung im Gerät. Es kann eine geringere Stromaufnahme aus einer Netzsteckdose erreicht werden, da nur Wirkleistung entnommen wird. Alternativ oder zusätzlich werden längere Einspeisezeiten möglich. Der Wandler 32 kann ein bidirektionaler DC/DC-Wandler sein.

Die Zwischenkreisspannung des Wandlers kann eine steuerbare Einrichtung 35 speisen, die nachfolgend noch ausführlicher beschrieben wird. Die steuerbare Einrichtung 35 kann ein 4-Quadranten-Verstärker sein.

Der Wandler 32 kann eingangsseitig mit einem Anschluss 21 zur Verbindung mit einer externen Energiequelle, beispielsweise einer Netzsteckdose gekoppelt sein. Der Wandler 32 kann eingangsseitig mit einer Batterie oder einem anderen Energiespeicher gekoppelt sein. Die Batterie oder der andere Energiespeicher kann in dem Gehäuse 11 der Prüfvorrichtung 10 integriert sein.

Der Wandler 32 kann wenigstens einen steuerbaren Schalter umfassen. Der wenigstens eine steuerbare Schalter kann ein Schalter einer Voll- oder Halbbrücke sein. Der wenigstens eine steuerbare Schalter kann getaktet geschaltet werden.

Im Betrieb der Prüfvorrichtung 10 kann ein Prüfsignal in den Prüfling 70 eingeprägt oder an den Prüfling 70 angelegt werden. Eine Prüfantwort kann über die mit dem Prüfling verbindbaren Anschlüsse 22, 23 erfasst werden, die mit wenigstens einer Messeinrichtung 14, 15 verbunden sind.

Die Steuereinrichtung 20 kann eingerichtet sein, um abhängig von der Prüfantwort des Prüflings auf das Prüfsignal Kenngrößen des Prüflings ermitteln. Die Steuereinrichtung 20 kann eine oder mehrere integrierte Halbleiterschaltungen, beispielweise eine anwendungsspezifische Spezialschaltungen (ASIC, "application specific integrated circuit"), einen Controller, einen Mikrocontroller, einen Prozessor, einen Mikroprozessor oder eine Kombination davon umfassen. Die Steuereinrichtung 20 kann den Wandler 32, die steuerbare Einrichtung 35 und optional weitere Einheiten der Prüfvorrichtung 10, wie beispielsweise eine Schaltmatrix, abhängig von einer Betätigung einer Benutzerschnittstelle der Prüfvorrichtung 10 steuern.

In unterschiedlichen Betriebszuständen, beispielsweise nach Betätigung eines Not-Aus-Knopfes, kann es wünschenswert sein, diese Energie rasch abzubauen. Dadurch kann die Betriebssicherheit erhöht werden. Alternativ oder zusätzlich kann ein rascher Abbau der in der Induktivität 71 gespeicherten Energie zwischen unterschiedlichen Prüfungsschritten einer mehrere Prüfungsschritte umfassenden Prüfungsprozedur erwünscht sein. Dadurch kann die für die Prüfung des Prüflings insgesamt benötigte Zeit verringert werden.

Zur Verringerung der in der Induktivität 71 gespeicherten Energie ist eine steuerbare Einrichtung 35 vorgesehen. Die steuerbare Einrichtung 35 kann ansteuerbar sein, um eine Gegenspannung zu der über der Induktivität 71 abfallenden Spannung zu erzeugen. Die steuerbare Einrichtung 35 kann von der Steuereinrichtung 20 der Prüfvorrichtung 10 wenigstens angesteuert werden, wenn die in der Induktivität 71 gespeicherte Energie abgebaut werden soll. Dies kann beispielsweise nach Betätigung eines Not-Aus-Schalters der Fall sein. Die steuerbare Einrichtung 35 kann von der Steuereinrichtung 20 abhängig davon, ob ein Normalbetrieb, in dem Energie von der Prüfvorrichtung 10 zum Prüfling 70 fließt, oder ein Notfallbetrieb, in dem die in der Induktivität 71 gespeicherte Energie abgebaut werden soll, gemäß unterschiedlichen Regelschleifen ansteuern. Beispielsweise kann dann, wenn die in der Induktivität 71 gespeicherte Energie rasch abgebaut werden soll, eine Regelung auf die Zwischenkreisspannung oder eine Leistungsregelung erfolgen.

Die steuerbare Einrichtung 35 kann, muss jedoch nicht in einer Regelschleife angesteuert werden. Beispielsweise kann die steuerbare Einrichtung 35 so angesteuert werden, dass dann, wenn Energie vom Prüfling 70 in die Prüfvorrichtung 10 zurückfließt, die zurückfließende Leistung und/oder die in der steuerbaren Einrichtung 35 dissipierte Leistung auf einen Leistungssollwert geregelt wird.

Die steuerbare Einrichtung 35 kann eingerichtet sein, um zum Abbauen der in der Induktivität 71 gespeicherten Energie eine Gegenspannung zu der Spannung über der Induktivität 71 zu erzeugen. Die Gegenspannung kann während wenigstens eines Teils der Zeitdauer, in der die in der Induktivität 71 gespeicherte Energie abgebaut wird, einen monoton zunehmenden Betrag aufweisen. Die steuerbare Einrichtung 35 kann von der Steuereinrichtung 20 so angesteuert werden, dass der Betrag der Gegenspannung, die zum Abbauen der in der Induktivität 71 gespeicherten Energie erzeugt wird, zunimmt, so lange die Zwischenkreisspannung am Ausgangs des Wandlers 32 konstant ist.

Die steuerbare Einrichtung 35 kann unterschiedliche Ausgestaltungen aufweisen. Die steuerbare Einrichtung 35 ist als Verstärker ausgestaltet, der sowohl bei einem Energiefluss von der Prüfvorrichtung 10 zum Prüfling 70 als auch zum Abbauen der in der Induktivität 71 gespeicherten Energie angesteuert wird. Bei weiteren Ausgestaltungen muss die steuerbare Einrichtung 35, die zum Reduzieren der Stromstärke des in der Induktivität fließenden Stroms beispielsweise bei einem Not-Aus-Betrieb angesteuert wird, nicht auch zum Speichern von Energie in der Induktivität 71 angesteuert werden. Beispielsweise können unterschiedliche Verstärker zum Laden und Entladen der Induktivität 71 verwendet werden.

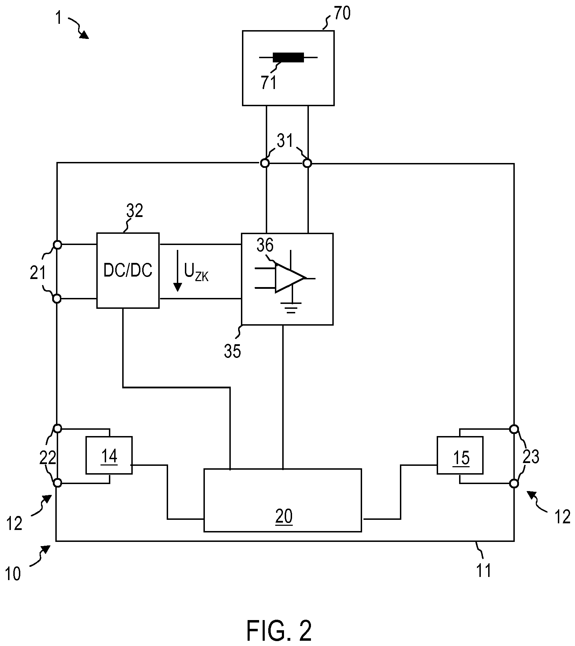

Figur 2 zeigt ein System 1 mit einer Prüfvorrichtung 10 zum Ermitteln einer Kenngrö-ße eines Prüflings 70 nach einem Ausführungsbeispiel. Einrichtungen, die in Funktion oder Ausgestaltung unter Bezugnahme auf Figur 1 beschriebenen Einrichtungen entsprechen können, sind mit denselben Bezugszeichen bezeichnet.

Die steuerbare Einrichtung 35, mit der zum Abbauen von in der Induktivität 71 gespeicherter Energie eine Gegenspannung zu der Spannung über der Induktivität 71 erzeugt wird, umfasst einen Verstärker.

Der Verstärker 36 kann ein 4-Quadranten-Verstärker sein. Der Verstärker 36 kann eingerichtet sein, um zum Aufbauen von Energie in der Induktivität 71 die Stromstärke des in der Induktivität 71 fließenden Stroms zu erhöhen. Der Verstärker 36 kann eingerichtet sein, um zum Abbauen von Energie in der Induktivität 71 die Stromstärke des in der Induktivität 71 fließenden Stroms zu verringern. Dazu kann der Verstärker 36 eine Gegenspannung, die zeitlich veränderlich sein kann, zu der Spannung über der Induktivität 71 erzeugen, wie unter Bezugnahme auf Figur 1 beschrieben wurde.

Der Verstärker 36 kann von der Steuereinrichtung 20 abhängig davon, ob ein Energiefluss von der Prüfvorrichtung 10 zum Prüfling 70 erfolgen soll oder ob Energie in der Induktivität 71 abgebaut werden soll, so dass der Energiefluss vom Prüfling 70 über den Anschluss 31 zur Prüfvorrichtung 10 fließt, unterschiedlich gesteuert werden. Der Verstärker 36 kann von der Steuereinrichtung 20 so angesteuert werden, dass Strom und Spannung im Verstärker 36 in gleicher Richtung gerichtet sind, wenn ein Energiefluss von der Prüfvorrichtung 10 zum Prüfling 70 erfolgen soll. Dabei wird der Verstärker 36 im I. oder III. Quadranten eines U-I-Diagramms betrieben. Der Verstärker 36 kann von der Steuereinrichtung 20 so angesteuert werden, dass Strom und Spannung im Verstärker 36 in entgegengesetzten Richtungen gerichtet sind, wenn Energie in der Induktivität 71 abgebaut werden soll, so dass der Energiefluss vom Prüfling 70 ur Prüfvorrichtung 10 erfolgt. Dabei wird der Verstärker 36 im II. oder IV. Quadranten eines U-I-Diagramms betrieben. Dies kann beispielsweise der Fall sein, wenn nach einer Betätigung eines Not-Aus-Schalters die Steuereinrichtung 20 den Verstärker 36 ansteuert, um die Induktivität 71 zu entladen.

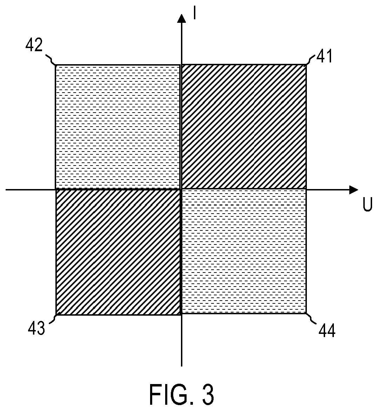

Figur 3 zeigt beispielhaft ein U-I-Diagramm eines Verstärkers 36 zur Erläuterung der Funktionsweise der Prüfvorrichtung 10 nach einem Ausführungsbeispiel. Der Verstärker 36 ist in der Prüfvorrichtung enthalten, um die Induktivität 71 zu entladen und dabei in der Induktivität 71 gespeicherte Energie zu dissipieren. Dabei wird der Verstärker so angesteuert, dass Strom und Spannung im Verstärker 36 in entgegengesetzten Richtungen gerichtet sind. Der Verstärker 36 wird im II. Quadranten 42 oder im IV. Quadranten 44 des U-I-Diagramms betrieben.

Der Verstärker 36 kann eingerichtet sein, um die Induktivität 71 zu laden und dabei in der Induktivität 71 gespeicherte Energie aufzubauen. Dabei wird der Verstärker so angesteuert, dass Strom und Spannung im Verstärker 36 in die gleiche Richtung gerichtet sind. Der Verstärker 36 wird im I. Quadranten 41 oder im III. Quadranten 43 des U-I-Diagramms betrieben.

Alternativ oder zusätzlich zu einer Umwandlung der vom Prüfling 70 in die Prüfvorrichtung 10 zurückfließenden Energie in Wärme kann wenigstens ein Teil der über den Anschluss 31 zurückfließenden Energie in einem Energiespeicher der Prüfvorrichtung 10, beispielsweise einem Kondensator des DC/DC-Wandlers 32, gespeichert werden und/oder über den DC/DC-Wandler 32 und den Anschluss 21 in das Netz zurückgespeist werden. Dazu kann der DC/DC-Wandler 32 ein bi-direktionaler DC/DC-Wandler 32 sein.

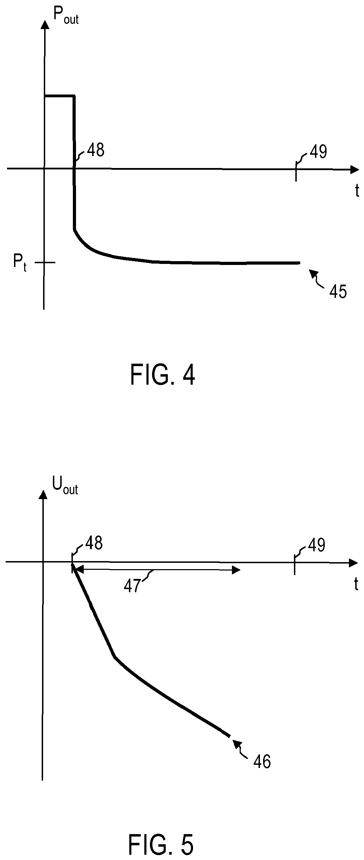

Figur 4 zeigt einen beispielhaften Verlauf einer Ausgangsleistung 45 am Anschluss 31, die resultiert, wenn der Verstärker 36 zum Reduzieren der Stromstärke des in der Induktivität 71 fließenden Stroms angesteuert wird.

Zu einem Zeitpunkt 48 kann die Steuereinrichtung 20 erkennen, dass die Stromstärke des in der Induktivität 71 fließenden Stroms reduziert werden soll, beispielsweise um die Induktivität 71 zu entmagnetisieren. Die Steuereinrichtung 20 kann eine Benutzerschnittstelle der Prüfvorrichtung 10 überwachen, um zu erkennen, ob ein Not-Aus-Schalter betätigt wurde und kann als Reaktion darauf die Reduzierung der in der Induktivität 71 gespeicherten Energie einleiten. Die Steuereinrichtung 20 kann alternativ oder zusätzlich einen Ablauf einer Prüfungsprozedur des Prüflings steuern und kann abhängig von dem Ablauf die Reduzierung der in der Induktivität 71 gespeicherten Energie einleiten.

Die steuerbare Einrichtung 35 wird so angesteuert, dass sich die Richtung des Leistungsflusses am Anschluss 31 umkehrt. Die steuerbare Einrichtung 35 kann gemäß einer Regelschleife so gesteuert werden, dass die von der steuerbaren Einrichtung 35 dissipierte Leistung und/oder die vom Prüfling 70 zurückfließende Leistung auf einen Leistungssollwert geregelt wird.

Der Betrag einer von dem 4-Quadranten-Verstärker 36 erzeugten Gegenspannung kann während eines Zeitintervalls monoton zunehmen. Der Betrag der Gegenspannung kann abhängig von der in Zeitableitung des Stroms in der Induktivität 71 eingestellt werden. Der Betrag der Gegenspannung kann von der Steuereinrichtung 20 zeitabhängig eingestellt werden.

Zu einem Zeitpunkt 49 kann die Reduzierung der Stromstärke in der Induktivität 71 beendet werden. Die Steuereinrichtung 20 kann beispielsweise abhängig davon, ob die Zwischenkreisspannung konstant ist oder ob die Induktivität 71 entmagnetisiert ist, den Vorgang der Reduzierung der in der Induktivität 71 gespeicherten Energie beenden.

Während des in Figur 4 illustrierten Betriebszustands kann der Verstärker 36 so betrieben werden, dass Strom und Spannung im Verstärker 36 in entgegengesetzten Richtungen gerichtet sind, um in der Spule gespeicherte Energie im Verstärker 36 zu dissipieren. Alternativ oder zusätzlich kann Energie über den Verstärker 36 in das Netz zurückgespeist werden.

Figur 5 zeigt einen beispielhaften Verlauf einer Ausgangsspannung, die resultiert, wenn der Verstärker 36 zum Reduzieren der Stromstärke des in der Induktivität 71 fließenden Stroms angesteuert wird.

Die Gegenspannung 46 muss nicht im gesamten Zeitraum zwischen den Zeitpunkten 48, 49, in dem der Betrag der Stromstärke in der Induktivität verringert wird, monoton zunehmen. Beispielsweise kann die Gegenspannung 46 auch einen Abschnitt aufweisen, in dem sie abnimmt. Während eines Zeitintervalls 47 nimmt der Betrag der Gegenspannung monoton zu, während Energie vom Prüfling 70 zur Prüfvorrichtung 10 fließt.

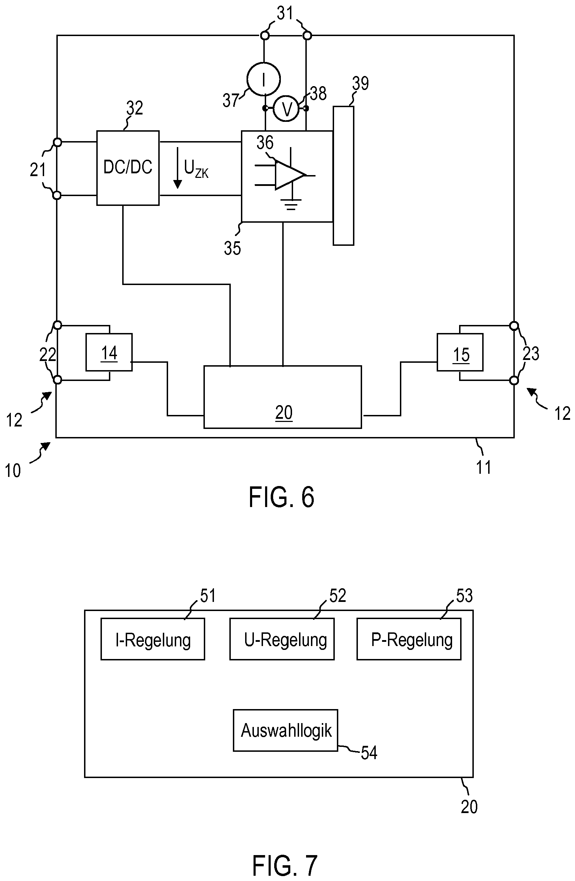

Figur 6 zeigt eine Prüfvorrichtung 10 zum Ermitteln einer Kenngröße eines Prüflings nach einem Ausführungsbeispiel. Einrichtungen, die in Funktion oder Ausgestaltung unter Bezugnahme auf Figur 1 bis Figur 5 beschriebenen Einrichtungen entsprechen können, sind mit denselben Bezugszeichen bezeichnet.

Die steuerbare Einrichtung 35, mit der zum Abbauen von in der Induktivität 71 gespeicherter Energie eine Gegenspannung zu der Spannung über der Induktivität 71 erzeugt wird, kann abhängig von einem Strom und/oder einer Spannung angesteuert werden, die von der Prüfvorrichtung 10 erfasst wird. Beispielsweise kann mit einem Amperemeter 37 oder einer anderen Strommesseinrichtung eine Stromstärke des über den Ausgang 31 fließenden Stroms erfasst werden. Mit einem Voltmeter 38 oder einer anderen Spannungsmesseinrichtung kann die Spannung am Ausgang 31 erfasst werden.

Ein Betrag der Gegenspannung, die von der steuerbaren Einrichtung 35 erzeugt wird, kann wenigstens in dem Betriebszustand, in dem die steuerbare Einrichtung 35 zum Verringern der in der Induktivität 71 gespeicherten Energie angesteuert wird, abhängig von der mit der Spannungsmesseinrichtung 38 erfassten Spannung und/oder abhängig von der mit der Strommesseinrichtung 37 erfassten Stromstärke eingestellt werden.

Die Steuereinrichtung 20 kann wenigstens in dem Betriebszustand, in dem die steuerbare Einrichtung 35 zum Verringern der in der Induktivität 71 gespeicherten Energie angesteuert wird, die steuerbare Einrichtung 35 so ansteuern, dass die von der steuerbaren Einrichtung 35 dissipierte Leistung in einer Regelschleife eingestellt wird.

Die Steuereinrichtung 20 kann wenigstens in einem weiteren Betriebszustand, in dem die steuerbare Einrichtung 35 so angesteuert wird, dass Energie von der Prüfvorrichtung 10 zum Prüfling 10 fließt, die steuerbare Einrichtung 35 so ansteuern, dass die von der steuerbaren Einrichtung 35 erzeugte Gegenspannung zu der Spannung über der Induktivität 71 als Stellgröße in einer Regelschleife eingestellt wird, mit der ein Ausgangsstrom der Prüfvorrichtung 10 geregelt wird.

Die Steuereinrichtung 20 kann so eingerichtet sein, dass sie automatische in eine Regelschleife umschaltet, die spezifisch zum Abbauen der in der Induktivität 71 gespeicherten Energie verwendet werden kann, wenn ein Ereignis detektiert wird, das anzeigt, dass die in der Induktivität 71 gespeicherte Energie verringert werden soll. Beispielsweise kann die Steuereinrichtung 20 bei der Erzeugung von Stellsignalen für den Verstärker 36 von einer weiteren Regelschleife, die eine Stromregelschleife sein kann, in eine Leistungsregelschleife umschalten, wenn die Prüfvorrichtung von einem Normalbetriebszustand in einen Betriebszustand wechselt, in dem die in der Induktivität 71 gespeicherte Energie aktiv abgebaut wird.

Figur 7 zeigt eine schematische Blockdarstellung einer Steuereinrichtung 20 der Prüfvorrichtung 10. Die Steuereinrichtung 20 kann zur Ausführung einer Mehrzahl von Regelschleifen eingerichtet sein. Die Steuereinrichtung 20 kann ein oder mehrere Speicherelemente 51 für eine erste Regelschleife umfasst. Die erste Regelschleife kann eine Stromstärkeregelung sein. Die Speicherelemente 51 für die erste Regelschleife können beispielsweise ein Register umfassen. Die Steuereinrichtung 20 kann alternativ oder zusätzlich ein oder mehrere Speicherelemente 52 für eine zweite Regelschleife umfasst. Die zweite Regelschleife kann eine Spannungsregelung sein. Die Speicherelemente 52 für die zweite Regelschleife können beispielsweise ein Register umfassen. Die Steuereinrichtung 20 kann alternativ oder zusätzlich ein oder mehrere Speicherelemente 53 für eine dritte Regelschleife umfasst. Die dritte Regelschleife kann eine Leistungsregelung sein. Die Speicherelemente 53 für die dritte Regelschleife können beispielsweise ein Register umfassen.

In einer, mehreren oder allen der Regelschleifen kann wenigstens ein Steuersignal für den Verstärker 36 erzeugt werden.

Die Steuereinrichtung 20 kann eine Auswahllogik 54 umfassen. Die Auswahllogik 54 kann nicht-flüchtig gespeicherte Operationen umfassen, nach denen die Steuereinrichtung 20 eine der mehreren Regelschleifen zum Erzeugen von Stellsignalen auswählt. Die Auswahllogik 54 kann eingerichtet sein, um abhängig davon, ob die in der Induktivität 71 gespeicherte Energie abgebaut werden soll, eine andere Regelschleife auszuwählen. Die Auswahllogik 54 kann eingerichtet sein, um als Reaktion auf die Detektion einer Betätigung eines Not-Aus-Schalters eine Regelschleife auszuwählen, die eine Leistungsregelschleife sein kann, um den Verstärker 36 so anzusteuern, dass er eine Gegenspannung zu der Spannung über der Induktivität 71 erzeugt.

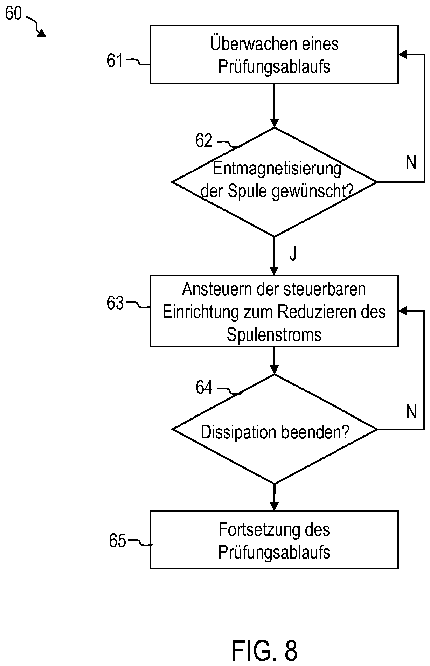

Figur 8 ist ein Flussdiagramm eines Verfahrens 60. Das Verfahren 60 kann von der Prüfvorrichtung 10 nach einem Ausführungsbeispiel automatisch ausgeführt werden.

Bei Schritt 61 kann ein Prüfungsablauf überwacht werden. Dazu kann die Steuereinrichtung 20 verfolgen, welche Prüfsignale erzeugt und/oder welche Prüfantworten erfasst werden sollen. Die Steuereinrichtung 20 kann den Wandler 32 und/oder weitere steuerbare Einrichtungen der Prüfvorrichtung 10 ansteuern, um die Prüfsignale zu erzeugen. Die Steuereinrichtung 20 kann Prüfantworten erfassen, aufzeichnen und optional auch auswerten.

Bei Schritt 62 wird überprüft, ob die in der Induktivität 71 gespeicherte Energie verringert werden soll. Die Überprüfung bei Schritt 63 kann beinhalten, dass die Betätigung eines Not-Aus-Schalters überwacht werden soll. Alternativ oder zusätzlich kann überwacht werden, ob ein Prüfungsschritt beendet wurde, nach dem die in der Induktivität 71 gespeicherte Energie reduziert werden soll. Falls die Stromstärke in der Induktivität 71 nicht verringert werden soll, kann das Verfahren zu Schritt 61 zurücckehren, um die Prüfung des Prüflings fortzusetzen.

Bei Schritt 63 kann, falls die Stromstärke in der Induktivität 71 verringert werden soll, die steuerbare Einrichtung 35 so angesteuert werden, dass sie eine zeitabhängig veränderliche Gegenspannung zu der Spannung über der Induktivität 71 erzeugt.

Die steuerbare Einrichtung 35 kann dabei angesteuert werden, um zum Abbauen der in der Induktivität 71 gespeicherten Energie eine Gegenspannung zu der Spannung über der Induktivität 71 zu erzeugen. Die Gegenspannung kann während wenigstens eines Teils der Zeitdauer, in der die in der Induktivität 71 gespeicherte Energie abgebaut wird, einen monoton zunehmenden Betrag aufweisen. Die steuerbare Einrichtung 35 kann so angesteuert werden, dass der Betrag der Gegenspannung, die zum Abbauen der in der Induktivität 71 gespeicherten Energie erzeugt wird, zunimmt, so lange eine Zwischenkreisspannung der Prüfvorrichtung 10 konstant ist. Die steuerbare Einrichtung 35 kann so angesteuert werden, dass eine in der 4-Quadranten-Diode 36 dissipierte Leistung auf einen Leistungssollwert geregelt wird.

Bei Schritt 64 kann überprüft werden, ob die in der Induktivität 71 gespeicherte Energie ausreichend abgebaut wurde. Dazu kann überprüft werden, ob die Stromstärke des in der Induktivität 71 fließenden Stroms bis auf einen Stromschwellenwert reduziert wurde und/oder ob die gesamte von der 4-Quadranten-Diode 36 dissipierte Energie oder die über das Prüfgerät 10 in das Netz zurück gespeiste Energie einen Energieschwellenwert erreicht. Falls die in der Induktivität 71 gespeicherte Energie nicht ausreichend abgebaut wurde, kann das Verfahren zu Schritt 63 zurückkehren.

Bei Schritt 65 kann die Prüfungsprozedur fortgesetzt werden. Dazu kann die steuerbare Einrichtung 35 so angesteuert werden, dass ein Energiefluss von der Prüfvorrichtung 70 zum Prüfling 10 erfolgt, so dass Energie in der Induktivität 71 wieder aufgebaut wird.

Bei Schritt 65 kann eine Prüfantwort des Prüflings erfasst und ausgewertet werden. Die Prüfantwort kann weiter verarbeitet werden, um eine oder mehrere Kenngrößen des Prüflings zu ermitteln.

Die ermittelten Kenngrößen können abhängig vom Prüfling variieren. Beispielsweise können bei einer Transformatorprüfung Übersetzungsverhältnisse, Reaktanzen, Kurzschlussimpedanzen, Längswiderstände oder andere Kenngrößen ermittelt werden. Bei der Prüfung eines Schutzschalters kann ermittelt werden, bei welcher Stromstärke der Schutzschalter auslöst.

Das Verfahren kann zu Schritt 61 zurückkehren.

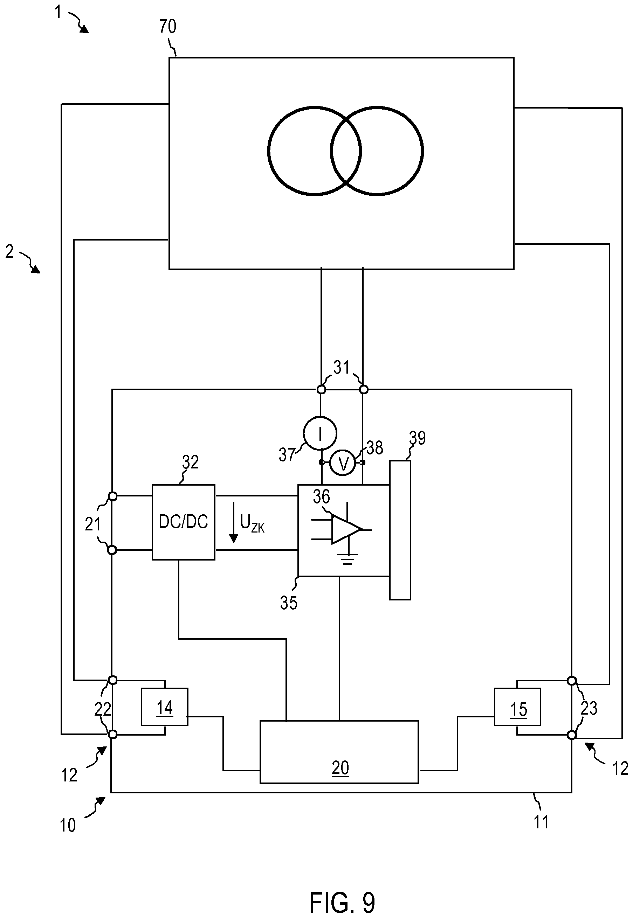

Figur 9 zeigt ein System 1 mit einer Prüfvorrichtung 10 nach einem Ausführungsbeispiel.

Das System 1 umfasst einen Prüfling 70, der ein Transformator sein kann. Der Prüfling 70 kann ein Zweiwicklungstransformator oder ein Dreiwicklungstransformator sein.

Die Prüfvorrichtung 10 kann als ein Transformatorprüfgerät ausgestaltet sein, das portabel sein kann. Die Prüfvorrichtung 10 kann eingerichtet sein, um eine oder mehrere Kenngrößen des Prüflings 70 automatisch zu ermitteln. Beispiele für derartige Kenngrößen beinhalten ein Übersetzungsverhältnis, eine Streureaktanz und einen Längswiderstand. Die Prüfvorrichtung 10 kann jede der unter Bezugnahme auf Figur 1 bis Figur 8 beschriebenen Ausgestaltungen aufweisen.

Mit Prüfvorrichtungen und Verfahren, wie sie unter Bezugnahme auf Figur 1 bis Figur 9 beschrieben wurden, kann eine in einer Induktivität gespeicherte Energie rasch abgebaut werden. Dazu kann eine steuerbare Einrichtung verwendet werden, die die Energie aktiv verringert, beispielsweise durch Erzeugen einer Gegenspannung zu der über der Induktivität 71 abfallenden Spannung.

Während Ausführungsbeispiele unter Bezugnahme auf die Figuren detailliert beschrieben wurden, können bei weiteren Ausführungsbeispielen alternative oder zusätzliche Merkmale verwendet werde. Während beispielsweise bestimmte Messungen wie die Bestimmung von Übersetzungsverhältnissen, von Widerständen, von Streureaktanzen und/oder Streuinduktivitäten beispielhaft beschrieben wurden, können durch die Prüfvorrichtungen alternativ oder zusätzlich andere Kenngrößen des Prüflings bestimmt werden.

Während bei Ausführungsbeispielen die steuerbare Einrichtung der Prüfvorrichtung ein Leistungsverstärker in Form eines 4-Quadranten-Verstärkers sein kann, können die beschriebenen Techniken auch andere steuerbare Einheiten aufweisen. Beispielsweise kann die steuerbare Einrichtung einen bi-direktionalen Wandler umfassen. Zum Reduzieren der Stromstärke des in der Induktivität fließenden Stroms kann die vom Prüfling in die Prüfvorrichtung zurückfließende Energie wenigstens teilweise in ein Netz zurückgespeist werden.

Vorrichtung, Verfahren und Systeme nach Ausführungsbeispielen erlauben eine sichere und zuverlässige Verringerung der in einer Induktivität gespeicherten Energie bei Prüfvorrichtungen für eine Prüfung eines Prüflings, beispielsweise für eine Transformatorprüfvorrichtung.

## Patentansprüche

1. Prüfvorrichtung zur Prüfung eines Prüflings (70) einer energietechnischen Einrichtung, wobei bei der Prüfung Energie in einer Induktivität (71) des Prüflings (70) gespeichert wird, wobei die Prüfvorrichtung (10) umfasst:
einen Ausgang (31), welcher zerstörungsfrei lösbar mit dem Prüfling (70) elektrisch leitend verbindbar ist,
eine steuerbare Einrichtung (35) zum Reduzieren einer Stromstärke eines in der Induktivität (71) fließenden Stroms, und
eine Steuereinrichtung (20) zum Steuern der steuerbaren Einrichtung (35),
**dadurch gekennzeichnet,**
**dass** die steuerbare Einrichtung (35) einen Verstärker (36) umfasst,
wobei die Steuereinrichtung (20) derart ausgestaltet ist, dass sie die steuerbare Einrichtung (35) zum Reduzieren der in der Induktivität (71) gespeicherten Energie ansteuert, wobei die Prüfvorrichtung zum Reduzieren der in der Induktivität (71) gespeicherten Energie über den Verstärker (36) der steuerbaren Einrichtung (35) ausgestaltet ist, um die Stromstärke des in der Induktivität (71) fließenden Stroms zu reduzieren, wobei ein Energiefluss von dem Prüfling (70) über den Ausgang (31) zu der Prüfvorrichtung (10) erfolgt.

2. Prüfvorrichtung nach Anspruch 1,
wobei die steuerbare Einrichtung (35) eingerichtet ist, um zum Reduzieren der Stromstärke eine zeitabhängig veränderliche Gegenspannung (46) zu erzeugen.

3. Prüfvorrichtung nach Anspruch 2,
wobei die Steuereinrichtung (20) eingerichtet ist, um die von der steuerbaren Einrichtung (35) erzeugte Gegenspannung (46) in einer Regelschleife einzustellen.

4. Prüfvorrichtung nach Anspruch 3 ,
wobei die Steuereinrichtung (20) eingerichtet ist, um die steuerbare Einrichtung (35) in einer Regelschleife zum Regeln einer von der steuerbaren Einrichtung (35) dissipierten Leistung zu steuern.

5. Prüfvorrichtung nach einem der Ansprüche 2 bis 4,
wobei die steuerbare Einrichtung (35) eingerichtet ist, um die Gegenspannung (45) derart zu erzeugen, dass ein Betrag der Gegenspannung (45) während eines Zeitintervalls (47) monoton zunimmt.

6. Prüfvorrichtung nach Anspruch 5,
wobei die steuerbare Einrichtung (35) so eingerichtet ist, dass der Betrag der Gegenspannung (46) zunimmt, so lange eine Zwischenkreisspannung, mit der die steuerbare Einrichtung (35) gespeist wird, konstant ist.

7. Prüfvorrichtung nach einem der vorhergehenden Ansprüche,
wobei die Prüfvorrichtung (10) eingerichtet ist, um zum Speichern von Energie in der Induktivität (71) über die steuerbare Einrichtung (35) Energie zuzuführen und um zum Reduzieren der Stromstärke in der Induktivität (71) gespeicherte Energie über die steuerbare Einrichtung (35) zu dissipieren.

8. Prüfvorrichtung nach einem der vorhergehenden Ansprüche,
wobei die steuerbare Einrichtung (35) einen 4-Quadranten-Verstärker (36) umfasst.

9. Prüfvorrichtung nach einem der vorhergehenden Ansprüche,
die als Transformatorprüfgerät oder als Wandlerprüfgerät ausgestaltet ist.

10. System, umfassend
einen Prüfling (70), der eine Induktivität (71) umfasst, und
eine Prüfvorrichtung (10) nach einem der vorhergehenden Ansprüche, die mit dem Prüfling (70) verbunden ist, um eine Stromstärke eines in der Induktivität (71) fließenden Stroms zu verringern.

11. Verfahren zum Steuern einer Prüfvorrichtung (10), wobei die Prüfvorrichtung (10) zur Prüfung eines Prüflings (70), der eine Induktivität (71) zum Speichern von Energie umfasst, eingerichtet ist, wobei das Verfahren umfasst:
elektrisch leitendes und zerstörungsfrei lösbares Verbinden des Prüflings (70) mit einer steuerbaren Einrichtung (35) der Prüfvorrichtung (10) über einen Ausgang (31) der Prüfvorrichtung (10),
Ansteuern der steuerbaren Einrichtung (35) der Prüfvorrichtung (10) zum Reduzieren einer Stromstärke eines in der Induktivität (71) des Prüflings (70) fließenden Stroms, wenn in der Induktivität (71) gespeicherte Energie reduziert werden soll, wobei die steuerbare Einrichtung (35) einen Verstärker (36) umfasst, und
wobei die Prüfvorrichtung die in der Induktivität (71) gespeicherten Energie über den Verstärker (36) der steuerbaren Einrichtung (35) reduziert, um die Stromstärke des in der Induktivität (71) fließenden Stroms zu reduzieren, wobei ein Energiefluss von dem Prüfling (70) über den Ausgang (31) zu der Prüfvorrichtung (10) erfolgt.

12. Verfahren nach Anspruch 11,
das von der Prüfvorrichtung (10) nach einem der Ansprüche 1 bis 9 automatisch ausgeführt wird.

## Claims

1. A test device for testing a test specimen (70) of an energy-related unit, wherein energy is stored in an inductor (71) of the test specimen (70) during the test, wherein the test device (10) includes:
an output (31), which can be electrically connected to the test specimen (70) in a destruction-free releaseable manner,
a controllable unit (35) for reducing a current intensity of a current flowing in the inductor (71),
a controller (20) for controlling the controllable unit (35),
**characterized in that**
the controllable unit (35) comprises an amplifier (36),
wherein the controller (20) is configured such that it controls the controllable unit (35) to reduce the energy stored in the inductor (71), wherein the test device is configured for reducing the energy stored in the inductor (71) via the amplifier (36) of the controllable unit (35) to reduce the current intensity of the current flowing in the inductor (71), wherein an energy flow from the test specimen (70) takes place via the output (31) to the test device (10).

2. The test device as claimed in claim 1,
wherein the controllable unit (35) is configured for generating a time-varying countervoltage (46) in order to reduce the current intensity.

3. The test device as claimed in claim 2,
Wherein the controller (20) is configured for adjusting the countervoltage (46), which is generated by the controllable unit (35), in a closed loop.

4. The test device as claimed in claim 3,
wherein the controller (20) is configured for controlling the controllable unit (35) in a control loop in order to regulate a power dissipated by the controllable unit (35).

5. The test device as claimed in one of claims 2 to 4,
wherein the controllable unit (35) is configured for generating the countervoltage (45) in such a way that an absolute value of the countervoltage (45) increases monotonously during a time interval (47).

6. The test device as claimed in claim 5,
wherein the controllable unit (35) is configured in such a way that the absolute value of the countervoltage (46) increases for as long as an intermediate circuit voltage - by means of which the controllable unit (35) is supplied - is constant.

7. The test device as claimed in one of the preceding claims,
wherein the test device (10) is configured for feeding energy, via the controllable unit (35), in order to store energy in the inductor (71) and for dissipating energy stored in the inductor (71), via the controllable unit (35), in order to reduce the current intensity.

8. The test device as claimed in one of the preceding claims,
wherein the controllable unit (35) includes a four-quadrant amplifier (36).

9. The test device as claimed in one of the preceding claims,
which is designed as a transformer test device or as a converter test device.

10. A system, including
a test specimen (70) which includes an inductor (71), and
a test device (10) as claimed in one of the preceding claims, which is connected to the test specimen (70) in order to reduce a current intensity of a current flowing in the inductor (71).

11. A method for controlling a test device (10), wherein the test device (10) is configured for testing a test specimen (70), which includes an inductor (71) for storing energy, wherein the method includes:
electrically conducting and destruction-free releasable connecting of the test specimen (70) to a controllable unit (35) of the test device (10) via an output (31) of the test device (10),
actuating the controllable unit (35) of the test device (10) for reducing a current intensity of a current flowing in the inductor (71) of the test specimen (70) when energy stored in the inductor (71) is to be reduced,
wherein the controllable unit (35) comprises an amplifier (36),
wherein the test device reduces the energy stored in the inductor (71) via the amplifier (36) of the controllable unit (35) to reduce the current intensity of the current flowing in the inductor (71), wherein an energy flow from the test specimen (70) takes place via the output (31) to the test device (10).

12. The method as claimed in claim 11,
which is automatically carried out by the test device (10) as claimed in one of claims 1 to 9.

## Revendications

1. Dispositif de test permettant de tester un objet à tester (70) d'un appareil énergétique, de l'énergie étant stockée dans une inductance (71) de l'objet à tester (70) pendant le test, le dispositif de test (10) comprenant :
une sortie (31), laquelle peut être connectée d'une manière électriquement conductrice et de façon amovible de manière non destructive à l'objet à tester (70),
un appareil pouvant être commandé (35) permettant de réduire une intensité de courant d'un courant circulant dans l'inductance (71), et
un appareil de commande (20) permettant de commander l'appareil pouvant être commandé (35), **caractérisé en ce**
**que** l'appareil pouvant être commandé (35) comprend un amplificateur (36),
l'appareil de commande (20) étant configuré de telle sorte qu'il commande l'appareil pouvant être commandé (35) pour réduire l'énergie stockée dans l'inductance (71), le dispositif de test étant configuré pour réduire l'énergie stockée dans l'inductance (71) par l'intermédiaire de l'amplificateur (36) de l'appareil pouvant être commandé (35) afin de réduire l'intensité de courant du courant circulant dans l'inductance (71), un flux d'énergie ayant lieu à partir de l'objet à tester (70) jusqu'au dispositif de test (10) par l'intermédiaire de la sortie (31).

2. Dispositif de test selon la revendication 1,
l'appareil pouvant être commandé (35) étant configuré pour produire une contre-tension (46) variant en fonction du temps pour réduire l'intensité de courant.

3. Dispositif de test selon la revendication 2,
l'appareil de commande (20) étant configuré pour régler la contre-tension (46) produite par l'appareil pouvant être commandé (35) dans une boucle de régulation.

4. Dispositif de test selon la revendication 3,
l'appareil de commande (20) étant configuré pour commander l'appareil pouvant être commandé (35) dans une boucle de régulation pour réguler une puissance dissipée par l'appareil pouvant être commandé (35).

5. Dispositif de test selon l'une des revendications 2 à 4,
l'appareil pouvant être commandé (35) étant configuré pour produire la contre-tension (45) de telle sorte qu'une valeur absolue de la contre-tension (45) augmente de manière monotone pendant un intervalle de temps (47).

6. Dispositif de test selon la revendication 5,
l'appareil pouvant être commandé (35) étant configuré de telle sorte que la valeur absolue de la contre-tension (46) augmente aussi longtemps qu'une tension de circuit intermédiaire, laquelle alimente l'appareil pouvant être commandé (35), est constante.

7. Dispositif de test selon l'une des revendications précédentes,
le dispositif de test (10) étant configuré pour acheminer de l'énergie par l'intermédiaire de l'appareil pouvant être commandé (35) afin de stocker de l'énergie dans l'inductance (71) et pour dissiper de l'énergie stockée dans l'inductance (71) par l'intermédiaire de l'appareil pouvant être commandé (35) afin de réduire l'intensité de courant.

8. Dispositif de test selon l'une des revendications précédentes,
l'appareil pouvant être commandé (35) comprenant un amplificateur à 4 quadrants (36).

9. Dispositif de test selon l'une des revendications précédentes,
lequel est conçu sous forme d'instrument de test de transformateur ou sous forme d'instrument de test de convertisseur.

10. Système, comprenant
un objet à tester (70), lequel comprend une inductance (71), et
un dispositif de test (10) selon l'une des revendications précédentes, lequel est connecté à l'objet à tester (70), afin de réduire une intensité de courant d'un courant circulant dans l'inductance (71).

11. Procédé permettant de commander un dispositif de test (10), le dispositif de test (10) étant configuré pour le test d'un objet à tester (70) qui comprend une inductance (71) permettant de stocker de l'énergie, le procédé comprenant :
la connexion d'une manière électriquement conductrice et de façon amovible de manière non destructive de l'objet à tester (70) à un appareil pouvant être commandé (35) du dispositif de test (10) par l'intermédiaire d'une sortie (31) du dispositif de test (10),
la commande de l'appareil pouvant être commandé (35) du dispositif de test (10) pour réduire une intensité de courant d'un courant circulant dans l'inductance (71) de l'objet à tester (70) lorsque de l'énergie stockée dans l'inductance (71) doit être réduite,
l'appareil pouvant être commandé (35) comprenant un amplificateur (36), et
le dispositif de test réduisant l'énergie stockée dans l'inductance (71) par l'intermédiaire de l'amplificateur (36) de l'appareil pouvant être commandé (35) afin de réduire l'intensité de courant du courant circulant dans l'inductance (71), un flux d'énergie ayant lieu à partir de l'objet à tester (70) jusqu'au dispositif de test (10) par l'intermédiaire de la sortie (31).

12. Procédé selon la revendication 11,
lequel est réalisé automatiquement par le dispositif de test (10) selon l'une des revendications 1 à 9.
